# FASCICULE DE BREVET EUROPEEN

(11) **EP 0 580 717 B1**
(45) Date de publication et mention de la délivrance du brevet: **27.09.1995**
(21) Numéro de dépôt: 92909766.5
(22) Date de dépôt: 15.04.1992
(51) Int. Cl.: H01S 3/19

(54) **DISPOSITIF OPTOELECTRONIQUE A TRES FAIBLE CAPACITE PARASITE ET SON PROCEDE DE FABRICATION**
OPTOELEKTRONISCHE VORRICHTUNG MIT EINER SEHR NIEDRIGEN PARASITISCHEN KAPAZITAT UND VERFAHREN ZU IHRER HERSTELLUNG
OPTOELECTRONIC DEVICE HAVING A VERY LOW PARASITIC CAPACITANCE AND ITS FABRICATION METHOD

(30) Priorité: 16.04.1991 FR 9104636
(43) Date de publication de la demande: 02.02.1994
(73) Titulaire: FRANCE TELECOM, 75015 Paris (FR)
(72) Inventeur: KAZMIERSKI, Christophe, F-91420 Morangis (FR); ROBEIN, Didier, F-92260 Fontenay-aux-Roses (FR)
(74) Mandataire: Dubois-Chabert, Guy
(86) Numéro de dépôt international: FR9200338
(87) Numéro de publication internationale: WO9219029

(56) Documents cités:
- PATENT ABSTRACTS OF JAPAN vol. 15, no. 200 (E-1070)22 Mai 1991 & JP-A-3 054 883
- OPTICAL FIBER COMMUNICATION CONFERENCE 1990 TECHNICAL DIGEST SERIES vol. 1, 22Janvier 1990, SAN FRANCISCO, CA, US page 213; T.SAZAKI ET AL.: 'A 2.5mA THRESHOLD CURRENT OPERATION AND 5-Gbits/s ZERO-BIAS CURRENT MODULATION OF 1.5micrometers MQW-DFB LASER DIODES'
- APPLIED PHYSICS LETTERS. vol. 51, no. 12, 21 Septembre 1987, NEW YORK US pages 874 - 876; H.ISHIGURO ET AL.: 'VERY LOW THRESHOLD PLANAR BURIED HETEROSTRUCTURE InGaAsP/InP LASER DIODES PREPARED BY THREE-STAGE METALORGANIC CHEMICAL VAPORDEPOSITION'
- SECOND INTERNATIONAL CONFERENCE-INDIUM PHOSPHIDE AND RELATED MATERIALS 23 Avril 1990, DENVER, COLORADO, US pages 161 - 164; B.I.MILLER ET AL.:'TERTIARYBUTYLARSINE AS A SUBSTITUTE FOR AsH3 : APPLICATION TO InGaAsP/InP PHOTONIC INTEGRATED CIRCUITS'
- ELECTRONICS LETTERS. vol. 23, no. 24, 19 Novembre 1987, ENAGE GB pages 1263 -1265; BOWERS ET AL.: 'HIGH-SPEED, POLYIMIDE-BASED SEMI-INSULATING PLANAR BURIED HETEROSTRUCTURES'
- APPLIED PHYSICS LETTERS. vol. 45, no. 7, 1 Octobre 1984, NEW YORK US pages 784- 786; M.RAZEGHI ET AL.: 'CW OPERATION OF 1.57 micrometers Ga(x)In(1-x)As(y)P(1-y)InP DISTRIBUTED FEEDBACK LASERS GROWN BY LOW-PRESSURE METALORGANIC CHEMICAL VAPOR DEPOSITION'

## Description

La présente invention concerne un dispositif optoélectronique à très faible capacité parasite et son procédé de fabrication. Elle s'applique notamment à la réalisation de lasers à semi-conducteurs, de modulateurs optiques ou d'amplificateurs à très grande vitesse de commutation commandée électriquement.

On connaît la structure dite BRS ("Buried Ridge Stripe" selon la terminologie anglo-saxonne usuelle) décrite dans l'article de J.C. Bouley et al., publié dans Proceedings of the 9th IEEE International Laser Conference, p. 54 (1984) qui permet la réalisation de dispositifs optoélectroniques à grande vitesse de commutation et en particulier de lasers semi-conducteurs.

Un laser à semi-conducteurs réalisé selon la technique BRS comporte un ruban comprenant une couche active à faible gap enfouie dans une couche de confinement de gap plus large. Le confinement est alors électrique et optique. Le ruban guide le faisceau lumineux produit lors de l'excitation électrique. La cavité optique nécessaire à l'obtention de l'effet laser est constituée par les extrémités clivées ou gravées du ruban.

Les dispositifs optoélectroniques réalisés selon la technique BRS répondent très rapidement aux excitations électriques : le temps de réponse ultime est limité par les processus de relaxation des porteurs dans les bandes de conduction et de valence ; il peut donc atteindre théoriquement des durées de l'ordre de la picoseconde.

Néanmoins, une telle vitesse de fonctionnement est limitée plus sévèrement par la structure même du composant et de ses éléments électriques parasites. En général, le circuit parasite est équivalent à un circuit RC où R est la résistance d'accès à la zone active et C une capacité parasite.

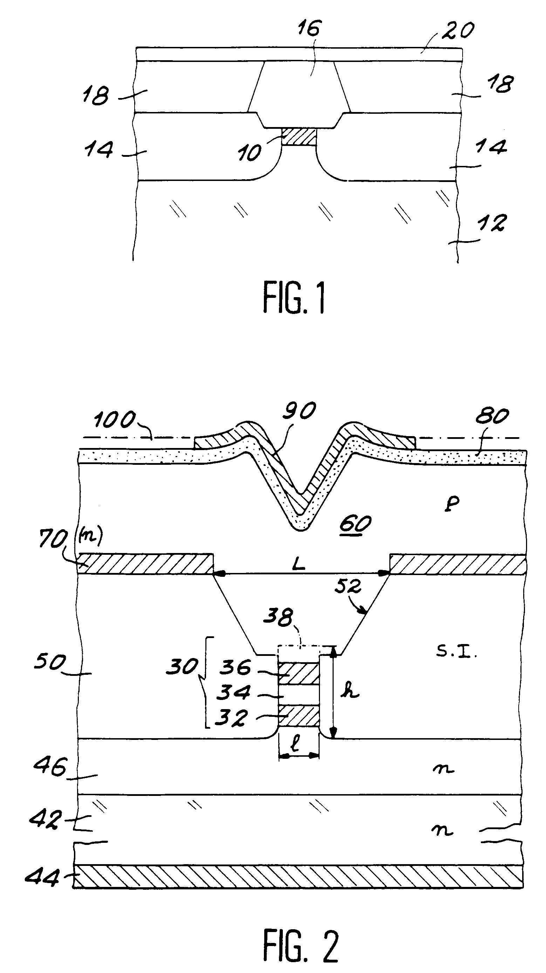

La figure 1 représente schématiquement une structure laser connue décrite dans l'article de J.E. Bowers et al., paru dans Electronics Letters, vol. 23, n° 24, p. 1263-1265, 19 Novembre 1987. Ce dispositif est dérivé d'une structure BRS et possède un temps de réponse amélioré.

Un ruban 10 comprenant une couche en matériau actif repose sur un substrat 12 en InP dopé n. Les deux côtés latéraux du ruban 10 sont entourés par une couche de confinement latéral 14 en InP semi-isolant.

Une couche de confinement vertical 16, en InP dopé p, repose à la verticale du ruban 10 dans un sillon correspondant à l'empreinte du masque diélectrique d'arrêt de croissance, utilisé lors de l'étape d'épitaxie sélective pour former la couche 14. La couche de confinement vertical 16 est tronquée et ses faces latérales sont entourées d'une couche diélectrique 18 en polyimide. Le profil de la couche 16 est obtenu par épitaxie sur l'ensemble de la structure puis gravure, selon un motif voulu, de cette couche 16.

La face supérieure est recouverte d'une couche de contact 20.

Le temps de réponse court (RC environ 4ps) d'une telle structure est obtenu grâce à la surface de contact limitée entre la couche de confinement vertical 16 et la couche semi-isolante 14. En effet, cette zone de contact lorsqu'elle est importante est une source de fuite de courant due à une diffusion d'accepteurs de la couche de confinement vertical 16 dans la couche semi-isolante 14 qui perd alors ses propriétés diélectriques.

Cette structure présente malgré tout un certain nombre d'inconvénients.

En effet, sa réalisation fait appel à une étape d'épitaxie sélective pour la constitution de la couche de confinement latéral semi-isolant 14. Or, la présence d'un masque d'arrêt de croissance de nature différente de celle de la couche semi-isolante (dont seule l'empreinte en forme de sillon est visible sur la figure 1) est une source de perturbations (contraintes mécaniques) et de défauts dans le matériau semi-isolant, plus spécialement en bordure de masque et donc à proximité directe de la couche active.

Ces défauts et perturbations sont responsables de fuites de courant augmentant ainsi la capacité parasite du composant et dans certains cas le courant de seuil.

Par ailleurs, lors de l'étape d'épitaxie de la couche 16 de confinement vertical, les diffusions du zinc (dopant p de la couche 16) vers la couche semi-isolante 14 et inversement du fer (dopant de la couche 14) vers la couche de confinement vertical 16 sont possibles entraînant des fuites de courant et donc une nouvelle augmentation de la capacité parasite.

En outre, la couche de confinement vertical 16 tronquée, du fait de sa faible largeur et de son entourage en polyimide, ne possède pas de bonnes propriétés thermiques. De plus, cette faible largeur augmente la résistance d'accès du composant, ce qui a pour conséquence d'élever le temps de réponse de la structure.

Il est connu, par ailleurs, par le document Optical Fiber Communication Conference 1990 Technical Digest Series, vol. 1, Janvier 1990 de T. Sasaki et al., p. 213, une structure laser comportant une couche d'isolement en InP dopé n entre la couche de confinement latéral semi-isolante en InP dopé avec des ions fer et une couche d'InP de type p.

La couche d'isolement en InP dopé n, de même composition que les couches de type p et semi-isolante, induit une capacité distribuée supplémentaire due à l'homo-jonction de cette couche et de la couche p. Par ailleurs, cette structure est fabriquée en trois étapes d'épitaxie dont l'une est malheureusement sélective pour déposer successivement la couche semi-isolante et la couche d'isolement, augmentant encore la capacité parasite de la structure.

La présence d'une capacité parasite élevée ralentit le fonctionnement en haute fréquence du dispositif.

La présente invention a pour objet un dispositif optoélectronique à très faible capacité parasite et son procédé de fabrication permettant notamment de remédier à ces inconvénients. Elle préconise une structure dans laquelle la zone active est entourée par un volume important de matériau semiconducteur et semi-isolant (pour la bonne tenue thermique du dispositif), sans faire appel à une épitaxie sélective (engendrant des défauts), et permettant de bloquer l'interdiffusion des accepteurs de la couche de confinement vertical vers la couche semi-isolante et du dopant de la couche semi-isolante vers la couche de confinement vertical.

Pour cela, une couche d'isolement en matériau différent de celui de la couche semi-isolante et de la couche de confinement vertical est déposée sur la couche semi-isolante, permettant ainsi d'étendre le dépôt de la couche de confinement vertical sans risque d'interdiffusion.

De manière plus précise, la présente invention concerne un dispositif optoélectronique comportant :
- une couche-substrat en matériau semiconducteur dopé n ;
- sur la couche-substrat, une couche de confinement latéral en matériau semi-conducteur dopé de manière à rendre ce matériau semi-isolant ;
- un ruban comprenant un matériau actif, ce ruban étant enterré dans la couche de confinement latéral et en contact avec la couche-substrat, la couche de confinement latéral ayant un sillon creusé au-dessus et le long du ruban ;
- une couche d'isolement en matériau semiconducteur dopé n déposée de part et d'autre du sillon sur la couche de confinement latéral ;
- une couche de confinement vertical en matériau semi-conducteur dopé p déposée sur la couche d'isolement et remplissant le sillon de la couche de confinement latéral, la couche d'isolement étant réalisée en un matériau de composition distincte de celle de la couche de confinement latéral et de celle de la couche de confinement vertical ;
- une première prise de contact électrique sur la couche de confinement vertical au moins à la verticale du ruban, et
- une seconde prise de contact électrique sur la couche-substrat.

La couche d'isolement conforme à l'invention permet de préserver le caractère semi-isolant de la couche de confinement latéral diminuant ainsi la capacité parasite du dispositif. En particulier, cette capacité est quatre fois plus faible que celle du dispositif de T. Sasaki cité précédemment. Ainsi, le dispositif de l'invention a une potentialité de fonctionnement quatre fois plus rapide que celui de T. Sasaki notamment à haute fréquence.

De manière avantageuse, la couche de confinement vertical présente une forme en V à la verticale du ruban comprenant le matériau actif, la première prise de contact électrique épousant cette forme.

La forme en V permet d'augmenter la surface de métallisation du contact et donc de diminuer la résistance de contact. Elle permet aussi de diminuer la résistance d'accès à la zone active et donc participe à l'amélioration du temps de réponse du dispositif.

Selon une réalisation particulière, la couche-substrat, la couche de confinement latéral et la couche de confinement vertical sont en un premier matériau semi-conducteur choisi dans la catégorie III-V, le ruban étant constitué de composants appartenant à la catégorie III-V, la couche d'isolement étant en un second matériau semi-conducteur de composition différente de celle du premier matériau, choisie dans la catégorie III-V.

Avantageusement, la couche d'isolement est en matériau semi-conducteur quaternaire, ce qui permet la réalisation d'une couche d'isolement très fine.

En particulier, la couche-substrat, la couche de confinement latéral et la couche de confinement vertical sont en InP, le matériau actif du ruban est en GaInAsP, GaInAs ou GaAlAs et la couche d'isolement est en GaInAsP.

Par GaInAsP, il faut comprendre un matériau en GaₓIn₁₋ₓ As_{y}P_{1-y} avec 0<x≦1 et 0<y≦1 et notamment en GaAs ; par GaAlAs, il faut comprendre un matériau en GaₓAl₁₋ₓ As avec 0<x≦1 ; par GaInAs, il faut comprendre un matériau en GaₓIn₁₋ₓ As avec 0≦x≦1 et ainsi de suite.

La couche-substrat peut consister en un matériau massif semi-conducteur dopé n ou en une couche semi-conductrice dopée n, épitaxiée sur un matériau support semi-conducteur qui peut être semi-isolant ou dopé n ou p.

Lors de l'utilisation d'un matériau support semi-isolant ou de type p, une gravure de celui-ci doit être effectuée jusqu'à la couche semi-conductrice de type n pour mettre à nu une partie de cette couche. La prise de contact électrique est alors formée sur cette partie mise à nu.

La présente invention concerne aussi un procédé de fabrication d'un dispositif optoélectronique comprenant les étapes suivantes :
a) - réalisation d'un ruban sur une couche-substrat semi-conductrice dopée n, comprenant au moins une couche en matériau actif et une couche supérieure d'arrêt de gravure,
b) - dépôt d'une couche de confinement latéral en matériau semi-conducteur dopé de manière à rendre ce matériau semi-isolant sur la couche-substrat et recouvrant le ruban,
c) - réalisation sur la couche de confinement latéral d'un masque de gravure en matériau semiconducteur dopé n de composition distincte de celle de la couche de confinement latéral, constituant une couche d'isolement et comportant une ouverture à la verticale du ruban,
d) - gravure d'un sillon dans la couche de confinement latéral, à la verticale du ruban en utilisant le masque de gravure, la profondeur du sillon étant limitée par la couche d'arrêt de gravure,
e) - dépôt d'une couche de confinement vertical, sur la couche d'isolement, en un matériau semi-conducteur dopé p, de composition distincte de celle de la couche d'isolement, cette couche de confinement vertical remplissant le sillon, et
f) - réalisation d'une première et seconde prises de contact électrique sur respectivement la couche de confinement vertical et la couche-substrat.

Avantageusement, on élimine la couche d'arrêt de gravure entre les étapes d) et e).

Avantageusement, le dépôt de la couche de confinement vertical est effectué par épitaxie en phase vapeur.

D'autres caractéristiques et avantages de l'invention apparaîtront mieux après la description qui suit donnée à titre explicatif et nullement limitatif.

La description se réfère à des dessins annexés sur lesquels :
- la figure 1, déjà décrite, représente schématiquement un dispositif optoélectronique conforme à l'art antérieur ;
- la figure 2 représente schématiquement, en coupe, un dispositif optoélectronique conforme à l'invention ;
- les figures 3a à 3e représentent schématiquement différentes étapes du procédé de réalisation d'un dispositif conforme à l'invention.

En référence à la figure 2, on décrit maintenant un dispositif optoélectronique conforme à l'invention. Dans cet exemple de réalisation, les matériaux semi-conducteurs sont choisis dans la catégorie III-V sans que ceci constitue pour autant une limitation du domaine d'application de l'invention.

Comme on peut le voir sur la figure 2, un ruban actif 30 comprenant un matériau actif repose sur un substrat monocristallin 42 par exemple en InP dopé n. Le dopant n peut être du silicium, soufre, étain ; sa concentration est comprise dans une fourchette allant de 5.10¹⁷ à 3.10¹⁸ at/cm³ et, par exemple, est égale à 1.10¹⁸ at/cm³.

La surface inférieure du substrat 42 de type n est métallisée pour former une électrode 44 par exemple en TiAu.

Dans l'exemple représenté, la face supérieure du substrat 42 est pourvue d'une couche-tampon 46 (appelée couche-substrat) elle aussi en InP dopé n par exemple avec du silicium à une concentration de 1.10¹⁸ at/cm³.

Dans la réalisation représentée, le ruban actif 30 comprend trois couches 32, 34, 36.

La première couche 32 est en matériau actif. Elle peut être réalisée en GaₓIn₁₋ₓAs_{y}P_{1-y} massif avec 0≦x≦1 et 0≦y≦1 et par exemple en Ga_{0,24}In_{0,76}As_{0,52}P_{0,48} pour l'émission laser à 1,3 µm ou bien en Ga_{0,39}In_{0,61}As_{0,87}P_{0,13} pour l'émission laser à 1,55µm, en GaₓIn₁₋ₓ As avec 0≦x≦1, en GaAs ou encore en GaₓAl₁₋ₓ As avec 0≦x≦1.

La couche 32 peut encore être composée d'un empilement de couches alternativement en GaInAs et GaInAsP de manière à former une structure à "puits quantiques" ou super-réseau et comportée un guide optique en GaInAsP à composition constante ou graduelle mais différente de la composition du matériau à "puits quantiques". De cette manière, le dispositif peut fonctionner dans une gamme de longueurs d'onde allant de 1200 à 1600nm.

Par exemple, pour un fonctionnement à 1550nm, les compositions respectives peuvent être Ga_{0,47}In_{0,53}As et Ga_{0,24}In_{0,76}As_{0,52}P_{0,48}.

La seconde couche 34 du ruban est une couche de protection de la couche en matériau actif d'épaisseur comprise entre 0,01 et 0,1 micromètre ; elle peut être en InP de type p par exemple dopé au Zn à la concentration 5.10¹⁷ at/cm³.

Cette couche de protection évite le contact de la couche active avec l'air notamment au cours de la fabrication ou avec une autre couche.

Dans la réalisation représentée sur la figure 2, le ruban 30 comporte une troisième couche 36. Cette couche 36 est facultative, elle réalise un réseau de Bragg périodique de miroir distribué ("Distributed Feedback" en terminologie anglo-saxonne). La couche 36 peut être constituée par un empilement de couches en GaₓIn₁₋ₓAs_{y}P_{1-y} (avec x et y non nul simultanément) et InP par exemple : Ga_{0,24}In_{0,76}As_{0,52}P_{0,48} et InP. Le réseau est par exemple gravé chimiquement ou par gravure sèche ou par tout autre procédé connu.

Dans le cas où le dispositif comprend une telle couche 36, la couche de protection permet de contrôler la distance séparant la couche 36 et la couche active 32.

Le ruban 30 comprend éventuellement une couche supplémentaire d'arrêt de gravure 38 dont le rôle et la composition seront décrits plus loin.

Le ruban 30 présente une largeur l de 1 à 3µm, par exemple 2µm. Sa hauteur h est par exemple comprise entre 0,2 et 0,6µm.

Le ruban 30 est enterré dans une couche de confinement latéral 50 en matériau semi-conducteur dopé de manière à être semi-isolant. Le matériau peut être de l'InP dopé par exemple avec du fer en concentration pouvant aller de 1.10¹⁶at/cm³ à 5.10¹⁷at/cm³. La concentration peut par exemple être égale à 1.10¹⁷ at/cm³.

La couche de confinement latéral 50 comprend un sillon 52 creusé au-dessus et le long du ruban 30. Ce sillon permet de diminuer la surface de contact entre la couche de confinement latéral et une couche de confinement vertical décrite plus loin.

La forme du sillon résulte du type de gravure utilisé : rectangulaire, trapézoïdale, cylindrique ou combinaison de ces formes. L'ouverture supérieure L du sillon 52 présente une largeur comprise entre 1 et 5µm, par exemple 2µm environ.

La hauteur totale de la couche de confinement latéral est supérieure à 1µm et par exemple égale à 2µm ; elle résulte d'un compromis entre la nécessité d'une hauteur suffisante pour diminuer la capacité parasite du dispositif optoélectronique, l'obtention d'une bonne isolation et une surface de contact faible au niveau du sillon 52. Par ailleurs, on comprend que plus la hauteur du ruban 30 est importante, plus la surface de contact au niveau du sillon 52 est faible.

La couche de confinement latéral 50 est recouverte par une couche de confinement vertical 60 qui remplit le sillon 52. Cette couche 60 est en matériau semi-conducteur dopé p, par exemple en InP dopé avec du Zn en concentration comprise entre 1.10¹⁷ at/cm³ et 5.10¹⁸ at/cm³, par exemple 2.10¹⁸ at/cm³.

L'extension sur toute la largeur du dispositif de la couche de confinement vertical 60 permet de répartir la résistance d'accès du dispositif et de la diminuer au niveau du ruban 30. D'autre part, cette extension permet d'obtenir une bonne tenue thermique du dispositif.

Afin de limiter l'interdiffusion des dopants entre les couches de confinement latéral et vertical 50, 60, une couche d'isolement 70 est disposée de part et d'autre du sillon 52 à l'interface entre les couches de confinement 50, 60. Cette couche d'isolement 70 permet en particulier de préserver le caractère diélectrique de la couche semi-isolante et par là, contribue à la diminution de la capacité parasite.

Cette couche d'isolement est réalisée en matériau semi-conducteur dopé n de composition différente de celle du matériau utilisé pour les couches de confinement. De manière avantageuse, on utilise un matériau quaternaire, ce qui autorise une très faible épaisseur de couche, de l'ordre de 0,1µm.

La couche d'isolement 70 peut être en GaInAsP, Ga_{0,24}In_{0,76}As_{0,52}P_{0,48} dopé avec du silicium en concentration pouvant aller de 1.10¹⁶ à 2.10¹⁸ at/cm³ et par exemple égale à 1.10¹⁸ at/cm³.

La couche de confinement vertical 60 présente une forme en V à la verticale du ruban 30 comprenant le matériau actif.

Une couche de contact électrique 80 par exemple en Ga_{0,47}In_{0,53}As recouvre la surface supérieure de la couche de confinement vertical surface 60. Cette couche de contact est dopée p⁺ avec du Zn en concentration pouvant aller de 5.10¹⁸ à 2.10¹⁹ at/cm³ et par exemple égale à 1.10¹⁹ at/cm³. Un contact électrique est réalisé par une électrode 90 disposée au niveau du V. Cette électrode 90 est par exemple en TiPt.

La forme en V du contact électrique permet de diminuer la résistance d'accès à la couche active tout en diminuant la résistance de contact grâce à l'augmentation de la surface utile métallisée.

Eventuellement, le dispositif comprend une couche diélectrique 100 en Si₃N₄ ou SiO₂ déposée de part et d'autre de l'électrode 90. Cette couche 100 permet d'assurer une isolation électrique autour de l'électrode.

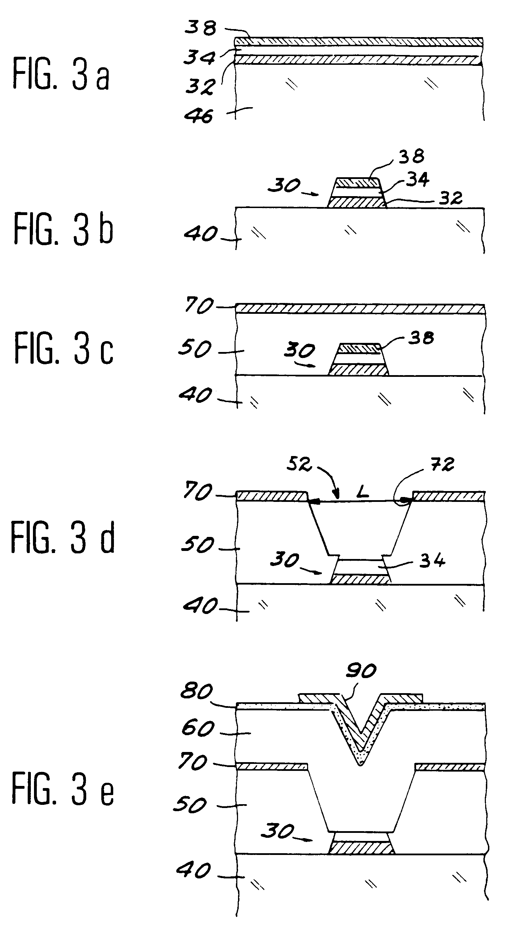

En référence aux figures 3a à 3e, on décrit maintenant le procédé de réalisation du dispositif optoélectronique conforme à l'invention.

On réalise tout d'abord (figure 3a), par exemple grâce à un cycle d'épitaxie en phase vapeur utilisant des organométalliques (MOVPE), une couche-substrat 46 monocristalline recouverte par une couche en matériau actif 32. La couche-substrat 46 est, comme on l'a vu précédemment, constituée d'InP dopé n.

La couche en matériau actif est recouverte par épitaxie MOVPE d'une couche de protection 34 en InP de type p puis d'une couche supérieure d'arrêt de gravure 38 ; cette couche d'arrêt, d'une épaisseur pouvant aller de 0,01 à 0,5µm et par exemple égale à 0,2µm, peut être en Ga_{0,24}In_{0,76}As_{0,52}P_{0,48} dopé p avec du zinc à la concentration 5.10¹⁷ at/cm³.

Ces premiers dépôts peuvent être aussi effectués suivant d'autres techniques connues d'épitaxie, par exemple l'épitaxie en phase liquide (LPE) ou l'épitaxie par jets moléculaires avec leurs variantes.

Une couche supplémentaire supportant un réseau de Bragg peut éventuellement être intercalée entre la couche 34 et la couche supérieure 38. La réalisation d'un tel réseau est connue et on en trouve par exemple une description dans l'article M. Razeghi et al., publié dans Applied Physics Letters, vol. 45 (1984), p. 784 ; la réalisation d'un tel réseau n'est donc pas détaillée ici afin d'alléger la description.

Les couches 32, 34, 36 sont ensuite gravées par exemple suivant la direction cristallographique <110>. La gravure peut être effectuée par une attaque chimique avec HBr:Br:H₂0 ou par une attaque ionique réactive du type "Reactive Ion Etching" ou "Reactive Ion Beam Etching" (RIE, RIBE) ou leurs combinaisons.

Par cette gravure, on réalise le ruban actif 30 (figure 3b).

On dépose ensuite sur l'ensemble de la structure, par exemple lors d'un second cycle d'épitaxie en phase vapeur, une couche semi-isolante de confinement latéral 50 recouverte d'une couche bloquante 70 (figure 3c) de composition différente de celle de la couche 50 et pouvant être gravée sélectivement par rapport à cette couche 50.

Une seconde gravure est ensuite effectuée : dans un premier temps, une ouverture 72 en regard du ruban 30 (d'une largeur pouvant aller de 1 à 5µm) est pratiquée sélectivement par photolithographie dans la couche bloquante 70 grâce à une solution de gravure n'agissant pas sur la couche semi-isolante 50. Dans le cas d'une couche bloquante en GaInAsP et d'une couche semi-isolante en InP, la solution de gravure peut être H₂SO₄:H₂O₂:H₂O (10:1:1).

Dans un second temps, on grave sélectivement la couche semi-isolante 50, la couche bloquante 70 servant alors de masque de gravure. Cette gravure effectuée par exemple à l'aide d'une solution de HCl:H₃PO₄ (2:1) est précisément stoppée par la couche d'arrêt de gravure, ici couche d'arrêt d'attaque chimique.

Eventuellement, de manière à éviter des pertes optiques, la couche d'arrêt de gravure 38 est éliminée sélectivement par exemple à l'aide d'une solution de H₂SO₄:H₂O₂:H₂O. La couche de protection 34 (ou la couche supportant le réseau) sert alors de couche d'arrêt de gravure, ici d'attaque chimique de la couche 38.

Le second cycle de gravure décrit ci-dessus est chimique, mais il est possible d'effectuer un usinage ionique et/ou plasma. Dans ce cas, les couches d'arrêt de gravure (couches 38 et 34 selon le type de gravure effectuée) permettent un contrôle de profondeur d'attaque en analysant les espèces ioniques ou moléculaires dans la chambre d'usinage. L'épaisseur de ces couches peut être alors extrêmement faible (de l'ordre de quelques nanomètres).

Comme on peut le voir sur la figure 3d, à la fin du second cycle de gravure, la couche de confinement latéral 50 est creusée d'un sillon 52 à la verticale du ruban 30. Elle est d'autre part recouverte par la couche bloquante 70 qui a servi de masque de gravure et qui servira par la suite de couche d'isolement.

On dépose ensuite, grâce à un cycle d'épitaxie en phase vapeur, une couche de confinement vertical 60 qui recouvre la couche d'isolement 70 et remplit le sillon 52. La couche de confinement vertical de composition différente de celle de la couche d'isolement est elle-même recouverte par une couche de contact électrique 80 déposée lors du même cycle d'épitaxie en phase vapeur.

L'épitaxie en phase vapeur permet de ménager dans ces couches de confinement vertical et de contact 60, 80 une forme en V à la verticale du ruban 30.

Une électrode 90 est constituée grâce à une métallisation (par exemple en TiPt) au niveau du V (figure 3e).

Le dispositif est entièrement réalisé lorsqu'on a déposé une électrode (par exemple en TiAu) sur la face inférieure de la couche-substrat de type n. On peut aussi, comme on l'a déjà indiqué, assurer une isolation électrique de la surface supérieure du dispositif grâce à un dépôt d'une couche diélectrique 100 (figure 2).

Si l'on désire utiliser le dispositif optoélectronique de l'invention en tant que laser, il est nécessaire de polir ou de cliver les faces du dispositif parallèles au plan de la figure 2.

Le dispositif optoélectronique de l'invention présente une bande passante pouvant être supérieure à 18GHz non limitée par le produit RC de la structure grâce entre autres à son mode de réalisation, qui évite le recours à une étape d'épitaxie sélective détériorant ce facteur, et à l'emploi d'une couche d'isolement de composition différente de celles des couches de confinement vertical et horizontal.

## Revendications

1. Dispositif optoélectronique comportant :
- une couche-substrat (46) en matériau semiconducteur dopé n ;
- sur la couche-substrat (46), une couche de confinement latéral (50) en matériau semi-conducteur dopé de manière à rendre ce matériau semi-isolant ;
- un ruban (30) comprenant un matériau actif (32), ce ruban (30) étant enterré dans la couche de confinement latéral (50) et en contact avec la couche-substrat (46), la couche de confinement latéral (50) ayant un sillon (52) creusé au-dessus et le long du ruban (30) ;
- une couche d'isolement (70) en matériau semi-conducteur dopé n déposée de part et d'autre du sillon (52) sur la couche de confinement latéral (50) ;
- une couche de confinement vertical (60) en matériau semi-conducteur dopé p déposée sur la couche d'isolement (70) et remplissant le sillon (52) de la couche de confinement latéral (50), la couche d'isolement étant réalisée en un matériau de composition distincte de celle de la couche de confinement latéral et de celle de la couche de confinement vertical ;
- une première prise de contact électrique (80, 90) sur la couche de confinement vertical au moins à la verticale du ruban (30), et
- une seconde prise de contact électrique (44) sur la couche-substrat (46).

2. Dispositif optoélectronique selon la revendication 1, caractérisé en ce que la couche de confinement vertical (60) présente une forme en V à la verticale du ruban (30) comprenant le matériau actif, la première prise de contact électrique (80, 90) épousant cette forme.

3. Dispositif optoélectronique selon la revendication 1 ou 2, caractérisé en ce que la couche-substrat (46), la couche de confinement latéral (50) et la couche de confinement vertical (60) sont en un premier matériau semi-conducteur choisi dans la catégorie III-V, le ruban (30) étant constitué de composants appartenant à la catégorie III-V, la couche d'isolement (70) étant en un second matériau semiconducteur de composition différente de celle du premier matériau choisie dans la catégorie III-V.

4. Dispositif optoélectronique selon l'une quelconque des revendications 1 à 3, caractérisé en ce que la couche d'isolement (70) est en matériau semiconducteur quaternaire.

5. Dispositif selon l'une quelconque des revendications 1 à 4, caractérisé en ce que le ruban comporte une couche de protection (34) sur le matériau actif.

6. Dispositif selon l'une quelconque des revendications 1 à 5, caractérisé en ce que la couche-substrat (46), la couche de confinement latéral (50) et la couche de confinement vertical (60) sont en InP, le matériau actif (32) du ruban (30) est en GaInAsP, CaInAs ou GaAlAs et la couche d'isolement (70) est en GaInAsP.

7. Procédé de fabrication d'un dispositif optoélectronique comportant les étapes suivantes :
a) - réalisation d'un ruban (30) sur une couche-substrat (46) semi-conductrice dopée n, comprenant au moins une couche en matériau actif (32) et une couche supérieure d'arrêt de gravure (38),
b) - dépôt d'une couche de confinement latéral (50) en matériau semi-conducteur dopé de manière à rendre ce matériau semi-isolant sur la couche-substrat et recouvrant le ruban (30),
c) - réalisation sur la couche de confinement latéral (50) d'un masque de gravure en matériau semiconducteur dopé n de composition distincte de celle de la couche de confinement latéral, constituant une couche d'isolement (70) et comportant une ouverture (72) à la verticale du ruban (30),
d) - gravure d'un sillon (52) dans la couche de confinement latéral (50), à la verticale du ruban (30) en utilisant le masque de gravure, la profondeur du sillon étant limitée par la couche d'arrêt de gravure (38),
e) - dépôt d'une couche de confinement vertical (60), sur la couche d'isolement (70), en un matériau semi-conducteur dopé p, de composition distincte de celle de la couche d'isolement, cette couche de confinement vertical (60) remplissant le sillon (52), et
f) - réalisation d'une première (80, 90) et seconde (44) prises de contact électrique sur respectivement la couche de confinement vertical (60) et la couche-substrat (46).

8. Procédé selon la revendication 7, caractérisé en ce que l'on élimine la couche d'arrêt de gravure (38) entre les étapes d) et e).

9. Procédé selon la revendication 7 ou 8, caractérisé en ce que le dépôt de la couche de confinement vertical (60) est effectué par épitaxie en phase vapeur.

## Patentansprüche

1. Optoelektronische Vorrichtung, bestehend aus:
- einer Trägerschicht (46), die aus einem mit n dotierten Halbleitermaterial besteht;
- einer auf der Trägerschicht (46) befindlichen Schicht zur seitlichen Begrenzung (50), die aus einem Halbleitermaterial besteht, das derart dotiert ist, daß dieses Material zu einem halbisolierenden Material wird;
- einem Streifen (30) aus einem aktiven Material (32), wobei dieser Streifen (30) in die seitliche Begrenzungsschicht (50) eingelassen und mit der Trägerschicht (46) in Kontakt ist und die seitliche Begrenzungsschicht (50) eine ausgehöhlte Rille (52) aufweist, welche über dem Streifen (30) und entlang dieses Streifens (30) verläuft;
- einer Isolierschicht (70) aus einem mit n dotierten Halbleitenmaterial, die auf beiden Seiten der Rille (52) auf der seitlichen Begrenzungsschicht (50) aufgehracht ist;
- einer senkrechten Begrenzungsschicht (60) aus mit p dotiertem Halbleitermaterial, die auf der Isolierschicht (70) aufgebracht ist und die Rille (52) der seitlichen Begrenzungsschicht (50) ausfüllt, wobei die Isolierschicht aus einem Material mit einer Struktur besteht, die sich von der Struktur der seitlichen Begrenzungsschicht und der Struktur der senkrechten Begrenzungssechicht unterscheidet;
- einen elektrischen Anschlußkontakt (80, 90) auf der senkrechten Begrenzungsschicht, der sich nindestens auf der Senkrechte des Streifens (30) befindet, und
- einen weiteren elektrischen Anschlußkontakt (44) auf der Trägerschicht (46).

2. Elektrooptische Vorrichtung nach Anspruch 1, dadurch gekennzeichnet, daß die senkrechte Begrenzungsschicht (60) die Form eines "V" auf der Senkrechten des das aktive Material enthaltenden Streifens (30) aufweist, wobei sich der erste elektrische Anschlußkontakt (80, 90) an diese Form anpaßt.

3. Elektrooptische Vorrichtung nach Anspruch 1 oder 2, dadurch gekennzeichnet, daß die Trägerschicht (46), die seitliche Begrenzungsschicht (50) und die senkrechte Begrenrungsschicht (60) aus einem Halbleitermaterial der Kategorie III-V bestehen, wobei der Streifen (30) aus Komponenten besteht, die der Kategorie III-Y angehören, und die Isolierschicht (70) aus einem weiteren Halbleitermaterial besteht, dessen Struktur sich von derjenigen des ersten Materials der Kategorie III-V unterscheidet.

4. Elektrooptische Vorrichtung nach einen der Ansprüche 1 bis 3, dadurch gekennzeichnet, daß die Isolierschicht (70) aus einem aus vier Stoffen zusammengesetzten Halbleitermaterial besteht.

5. Vorrichtung nach einem der Ansprüche 1 bis 4, dadurch gekennzeichnet, daß der Streifen eine Schutzschicht (34) enthält, die sich auf dem aktiven Material befindet.

6. Vorrichtung nach einem der Ansprüche 1 bis 6, dadurch gekennzeichnet, daß die Trägerschicht (46), die seitliche Begrenzungsschicht (50) und die senkrechte Begrenzungsschicht (60) aus InP bestehen, das aktive Material (32) des Streifens (30) aus GaInAsP, GaInAs oder GaAlAs und die Isolierschicht (70) aus GaInAsP bestehen.

7. Verfahren zur Herstellung einer elektrooptischen Vorrichtung, das aus folgenden Arbeitsschritten besteht:
a) - Bildung eines Streifens (30) auf einer mit n dotierten Halbleiterschicht (46), der mindestens eine Schicht aus aktiven Material (32) und eine obere Schicht (38) zum Stoppen der Ätzung enthält,
b) - Aufbringen einer seitlichen Begrenzungsschicht (50) aus einen Halbleitermaterial, das derart dotiert ist, daß dieses auf der Trägerschicht befindliche und den Streifen (30) bedeckende Material halbisolierend wird,
c) - Bildung einer Ätzmaske auf der seitlichen Begrenzungsschicht (50) aus mit n dotiertem Halbleitermaterial mit einer Struktur, die sich von derjenigen der seitlichen Begrenzungsschicht unterscheidet, die eine Isolierschicht (70) bildet und eine an der Senkrechten des Streifens (30) befindliche Öffnung (72) enthält,
d) - Einätzen einer Rille (52) in die seitliche Begrenzungsschicht (50) auf der Senkrechten des Streifens (30) unter Verwendung der Ätzmaske, wobei die Tiefe der Rille durch die Schicht zum Stoppen der Ätzung (38) begrenzt wird,
e) - Aufbringen einer senkrechten Begrenzungsschicht (60) auf die Isolierschicht (70), die aus einem mit p dotiertem Halbleitermaterial besteht und eine Struktur aufweist, die sich von derjenigen der Isolierschicht unterscheidet, wobei diese senkrechte Begrenzungsschicht (60) die Rille (52) ausfüllt, und
f) - Bildung eines ersten (80, 90) und zweiten (44) elektrischen Anschlußkontakts auf der senkrechten Begrenzungsschicht (60) bzw. auf der Trägerschicht (46).

8. Verfahren nach Anspruch 7, dadurch gekennzeichnet, daß zwischen den Arbeitsschritten d) und e) die Schicht zum Stoppen der Ätzung (38) eliminiert wird.

9. Verfahren nach Anspruch 7 oder 8, dadurch gekennzeichnet, daß das Aufbringen der senkrechten Begrenzungsschicht (60) durch Epitaxie in der Dampfphase erfolgt.

## Claims

1. Optoelectronic device comprising:
- a n-doped, semiconductor material substrate layer (46);
- on said substrate layer (46), a lateral confinement layer (50) of a semiconductor material doped so as to make it semi-insulating;
- a stripe (30) including an active material (32), said stripe (30) being buried in the lateral confinement layer (50) and in contact with the substrate layer (46), the lateral confinement layer (50) having a groove (52) hollowed out above and along the stripe (30);
- a n-doped, semiconductor material insulating layer (70) deposited on either side of the groove (52) on the lateral confinement layer (50);
- a p-doped, semiconductor material, vertical confinement layer (60) deposited on the insulating layer (70) and filling the groove (52) of the lateral confinement layer (50), the insulating layer being made from a material having a different composition from that of the lateral confinement layer and that of the vertical confinement layer;
- a first electrical contact (80, 90) on the vertical confinement layer at least vertically of the stripe (30); and
- a second electrical contact (44) on the substrate layer (46).

2. Optoelectronic device according to claim 1, characterized in that the vertical confinement layer (60) is V-shaped vertically of the stripe (30) including the active material, the first electrical contact (80, 90) adopting said shape.

3. Optoelectronic device according to claim 1 or 2, characterized in that the substrate layer (46), lateral confinement layer (50) and vertical confinement layer (60) are made from a first semiconductor material chosen from within category III - V, the stripe (30) being constituted by components belonging to category III - V, the insulating layer (70) being of a second semiconductor material having a composition different from that of the first material chosen in category III - V.

4. Optoelectronic device according to any one one of the claims 1 to 3, characterized in that the insulating layer (70) is a quaternary semiconductor material

5. Device according to any one of the claims 1 to 4, characterized in that the stripe has a protection layer (34) on the active material.

6. Device according to any one of the claims 1 to 5, characterized in that the substrate layer (46), the lateral confinement layer (50) and the vertical confinement layer (60) are of InP the active material (32) of the stripe (30) is of GalnAsP, GalnAs or GaAlAs and the insulating layer (70) is of GalnAsP.

7. Process for the production of an optoelectronic device comprising the following stages:
a) producing a stripe (30) on a n-doped, semiconductor substrate layer (46) , including at least one active material layer (32) and an upper etching stopping layer (38),
b) deposition of a lateral confinement layer (50) of a semiconductor material doped in such a way as to make said material semi-insulating on the substrate layer and covering the stripe (30),
c) producing on the lateral confinement layer (50) an etching mask made from a n-doped semiconductor material having a composition different from that of the lateral confinement layer, which constitutes an insulating layer (70) and has an opening (72) vertically of the stripe (30),
d) etching a groove (52) in the lateral confinement layer (50) vertically of the stripe (30) using the etching mask, the depth of the groove being limited by the etching stopping layer (38),
e) deposition of a vertical confinement layer (60), on the insulating layer (70), made from a p-doped semiconductor material and having a composition different from that of the insulating layer, said vertical confinement layer (60) filling the groove (52) and
f) producing a first (80, 90) and second (44) electrical contacts respectively on the vertical confinement layer (60) and the substrate layer (46).

8. Process according to claim 7, characterized in that the etching stopping layer (38) is eliminated between stages d) and e).

9. Process according to claim 7 or 8, characterized in that the deposition of the vertical confinement layer (60) takes place by vapour phase epitaxy.
